# EUROPEAN PATENT SPECIFICATION

(11) **EP 0 889 530 B1**
(45) Date of publication and mention of the grant of the patent: **17.04.2002**
(21) Application number: 98110308.8
(22) Date of filing: 05.06.1998
(51) Int. Cl.: H01L 29/423, H01L 29/10

(54) **Closed transistor with small W/L ratios**
Geschlossener Transistor mit niedrigen W/L-Verhältnissen
Transistor fermé avec des relations W/L basses

(30) Priority: 30.06.1997 US 885313
(43) Date of publication of application: 07.01.1999
(73) Proprietor: SIEMENS AKTIENGESELLSCHAFT, 80333 München (DE)
(72) Inventor: Poechmueller, Peter, Wappinger Falls, New York 12590 (US)
(74) Representative: Patentanwälte Westphal, Mussgnug & Partner

(56) References cited:
- DE-A- 3 925 123
- DE-A- 19 521 469
- GB-A- 2 020 484
- US-A- 4 240 093

## Description

### Field of Invention

The invention relates to semiconductor devices and, more particularly, to transistors with well defined threshold voltages and small W/L ratios.

### Background of the Invention

In device fabrication, insulating, semiconducting, and conducting layers are formed on a substrate or wafer. The layers are patterned to create features and spaces, forming devices, such as transistors, capacitors, and resistors. These devices are then interconnected to achieve a desired electrical function, resulting in an integrated circuit (IC) or chip.

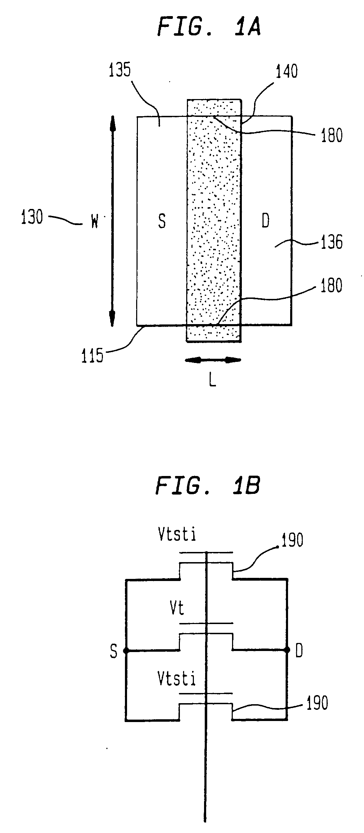

Referring to Fig. 1a, a conventional transistor layout or design is shown. As shown, an active area of the transistor comprises a gate 140, source 135, and drain 136. A relatively thin insulating layer is formed underneath the gate between the source and drain, which are highly doped regions. The insulating layer is referred to as a gate oxide. Application of a voltage at the gate exceeding a gate threshold voltage (V_{T}) creates a conducting channel beneath the gate. The conductive channel connects the source and drain, allowing current to flow therefrom.

The ratio of the width and length (W/L) of the channel determines the amount of current flow from source to drain. The higher the ratio, the higher the current flow. Thus, the length and width of the transistor depends on design parameters and requirements to achieve the desired W/L ratio.

An isolation region 130 surrounds the active area of the transistor to provide isolation from other devices. The isolation region typically comprises relatively thick silicon oxide (SiO₂) or other dielectric material. Various types of isolation, such as LOCOS or shallow trench isolation (STI), are used.

In the conventional transistor layout, parasitic transistor devices are formed at the borders 180 of the isolation region and the gate between the source and drain. The parasitic devices form because of the uncontrolled thickness of the oxide in the transition region between the STI oxide and the gate oxide. The additional parasitic transistors 190 are in parallel to the designed transistor, as shown in Fig. 1b.

Parasitic transistors, because the oxide thicknesses above the channel are not clearly defined, have poorly defined V_{T}s. Since the parasitic transistors are in parallel, their poorly defined V_{T}s cause an overall variation in the V_{T} of the device. Variations in the overall V_{T} of the designed device is undesirable, particular for applications such as reference voltage generators or differential amplifiers, which require precisely matching transistor devices and exact gate threshold voltages.

To prevent the adverse effects of parasitic transistors, closed transistor devices have been employed. In a closed transistor, the STI borders between the source and drain are avoided. Typically, the gate is realized as a closed ring over the active area. Although it is impossible to avoid STI edges under the gate, the STI edge however no longer connect areas with different potential (i.e., the source and drain). Therefore, no parasitic corner device is formed. DE-A-195 21 469 discloses a transistor according to the preamble of claim 1.

However, conventional closed transistor layout are not suited for low W/L ratios, such as ≤ 4. As some applications use low W/L ratios to achieve the desired current requirements, closed transistors cannot be used.

Thus, from the above discussion, it is desirable to provide a closed transistor with low W/L ratio.

### Summary of the Invention

The invention relates to a closed transistor according to claim 1 with a W/L ratio of ≤ about 1. The transistor includes a gate conductor folded around source and drain regions so as to avoid contact of the STI borders with regions of the transistor having different potentials. The folding of the gate around the source and drain results in well controlled width and length dimensions so as to achieve the claimed W/L ratio.

### Brief Description of the Drawings

Fig. 1a-1b show a layout of a conventional transistor and parasitic devices;
Fig. 2-3 show layouts of a conventional closed transistor; and
Fig. 4 shows a layout of an exemplary embodiment of the invention.

### Detailed Description of the Invention

The invention relates to ICs and, more particularly, to a closed transistor with low W/L ratio. ICs are typically fabricated on a semiconductor wafer in parallel. After processing is completed, the wafer is diced to separate the ICs into individual chips. For simplicity, the invention is described in the context of a closed transistor for use in an IC such as a memory device. The memory device includes random access memory (RAM) such as dynamic random access memory (DRAM), synchronous DRAM (SDRAM) or other memory IC. Other ICs, such as application specific ICs (ASICs) or logic devices, are also useful. To facilitate discussion of the invention, a description of a conventional W/L transistor is provided.

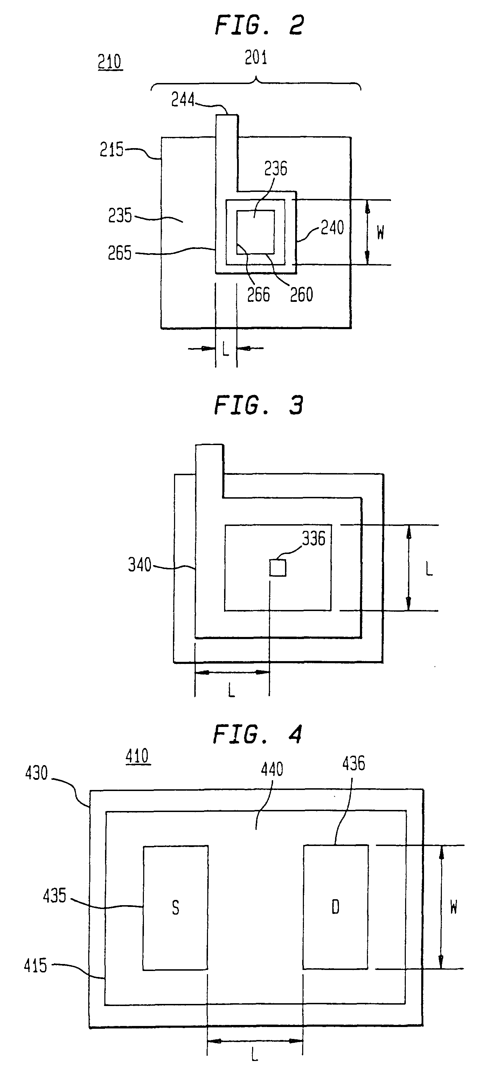

Referring to Fig. 2, a top view of a conventional closed transistor layout is shown. As shown, a closed transistor 201 is formed on the surface of a substrate 210. An active region 215, on which the transistor is formed, is defined in the substrate. Isolation region 230, such as STI surrounds the active region to isolate the transistor from other devices within the IC.

The transistor includes a gate 240. The gate is formed as a closed ring or loop within the active region 215. Inside and outside of the loop but within the active region are the source and drain regions 235 and 236, respectively. Thus, the gate separates the source and drain regions from each other. Underneath the gate is a gate oxide that forms a conductive channel when an appropriate voltage is applied to the gate, enabling current to flow between the source and drain.

As shown, a portion 244 of the gate overlaps the STI. The overlap portion is provided to enable a contact opening to be formed therein, as contact to the gate usually is prohibited over the active area due to design restrictions. As a result, the STI borders the gate at the overlap portion 244. However, this edge only connects areas of the source, which have the same potential. Since only areas having the same potential are connected, there is no flow of current. Thus, no parasitic transistors are formed.

The length and width of the device are adjusted by varying the width or length of the gate. However, the length and width of the gate of a closed transistor are not clearly defined due to the bending of the gate that is required to establish the closed loop. Typically, the device width W is approximated to be equal to the perimeter of the middle 260 of the inner and outer edges 265 and 266. The length is approximated to equal to the distance from the inner edge 265 to the outer edge 266.

A disadvantage of conventional closed transistors is their inability to achieve low W/L ratios. Referring to Fig. 3, a closed transistor with a W/L ratio of approximately 4 is shown. As shown, the transistor has an odd shape in that it has a very small drain region 336 located inside a gate loop 340. Such a transistor does not behave like a conventional straight transistor as shown in Fig. 1. This is because such shapes result in greater uncertainty in both the W and L. It is difficult to determine effective average of L since the physical gate length (distance from S to D) is up to 2^{1/2} x L where the gate bends. Likewise, it is difficult to determine W because the average perimeter cannot be the effective transistor width since the drain almost disappears. This also creates difficulties for layout verification tools since standard extraction tools cannot determine the effective W and L of such a layout. For large W/L ratios, the approximation of W and L are sufficiently accurate, but becomes problematic for W/L of less than about 4.

In accordance with the invention, a closed transistor layout with a W/L ratio of ≤ about 1 is provided. Fig. 4 shows a top view of illustrative layout of the invention. As shown, an active region 415 is provided on a substrate 410 which, for example, is a silicon wafer. Other substrate such as, for example, gallium arsenide or germanium, is also useful. The substrate is typically doped with dopants having a first conductivity. The substrate can be either lightly or heavily doped to achieve the desired electrical properties and performance. Surrounding the active region is a shallow trench isolation region 430 (STI). The STI comprises dielectric material such as SiO₂.

Source 435 and drain 436 regions are provided within the active region. Typically, the source and drain regions are heavily doped with dopants having a second conductivity. In one embodiment, the first conductivity is p-type and the second conductivity is n-type. P-type dopants include boron and n-type dopants include arsenic and phosphorous.

A gate conductor 440 is provided over the active region. The gate conductor comprises, for example, polysilicon (poly). Optionally, a polycide is useful to form the gate conductor. The gate is folded around or surrounds the source and drain to effectively prevent them from contacting the STI region. The gate overlaps the STI sufficiently to prevent the formation of parasitic resistors.

The transistor has well controlled W and L dimensions. As shown in Fig. 4, W is the dimension of the gate along the drain or source and L is the dimension of the gate from the drain to the source. Clearly from Fig.3, by adjusting W and/or L, a transistor with a W/L ratio of ≤ about 1 is obtainable in accordance with the invention.

## Claims

1. A closed transistor employed in integrated circuits, the transistor comprising:
an isolation region (430) surrounding an active device area (410), the isolation region (430) comprising a dielectric; and
the transistor being formed in a surface of the device area (410),
a gate (440) which overlaps the active device area (410),
a source (435) and a drain (436) located within the active device area (410) without contacting boundary between the isolation region (430) and active device area (410), wherein the source (435) and drain (436) are separated from each other by the gate (440) and the gate is folded around said source and drain;
**characterized in that** said isolation region (430) being a shallow trench isolation (STI) region and that said transistor having a W/L ratio of ≤ about 1, whereby W is the dimension of said gate (440) along said drain or source and L is the dimension of said gate (440)from said drain (436) to said source (435).

## Patentansprüche

1. Geschlossener Transistor in einer integrierten Schaltung, wobei der Transistor aufweist:
einen Isolationsbereich (430), der einen aktiven Bauelementbereich (410) umgibt, wobei der Isolationsbereich (430) ein Dielektrikum umfasst; und
wobei der Transistor in einer Oberfläche des Bauelementberei ches (410) gebildet ist,
ein Gate (440), das den aktiven Bauelementbereich (410) über lappt,
ein Source (435) und ein Drain (436), die innerhalb des akti ven Bauelementbereiches (410) angeordnet sind ohne die Grenze zwischen dem Isolationsbereich (430) und dem aktiven Bauelement (410) zu kontaktieren, wobei das Source (435) und das Drain (436) durch das Gate (440) voneinander getrennt sind und das Gate um Source und Drain gefaltet ist;
**dadurch gekennzeichnet,**
**dass** der Isolationsbereich (430) ein Bereich einer flachen Grabenisolation (shallow trench isolation = STI) ist und, dass der Transistor ein W/L-Verhältnis von ≤ etwa 1 aufweist, wobei W die Abmessung des Gates (440) entlang Drain oder Source und L die Abmessung des Gates (440) von Drain (436) zu Source (435) ist.

## Revendications

1. Transistor fermé utilisé dans des circuits intégrés, ce transistor comprenant :
une zone d'isolation (430) entourant une zone de dispositif active (410), la zone d'isolation (430) comprenant un diélectrique, et le transistor étant formé dans une surface de la zone de dispositif active (410) ;
une grille (440) qui recouvre la zone de dispositif active (410) ;
une source (435) et un drain (436) placés à l'intérieur de la zone de dispositif active (410) sans venir en contact avec la limite entre la zone d'isolation (430) et la zone de dispositif active (410), la source (435) et le drain (436) étant séparés l'un de l'autre par la grille (440) et la grille étant repliée autour de la source et du drain,
**caractérisé en ce que**
la zone d'isolation (430) est une zone d'isolation à tranchée peu profonde (STI) ; et
le transistor présente un rapport W/L inférieur ou égal à 1 environ, W étant le dimension de la grille (440) le long du drain ou de la source, tandis que L est la dimension de la grille (440) en allant du drain (436) à la source (435).
